# FASCICULE DE BREVET EUROPEEN

(11) **EP 3 380 647 B1**
(45) Date de publication et mention de la délivrance du brevet: **18.09.2019**
(21) Numéro de dépôt: 16721872.6
(22) Date de dépôt: 07.04.2016
(51) Int. Cl.: C23C 16/54, G05D 7/06, C23C 16/455, H01J 37/32, C23C 16/44, C23C 16/52, C23C 16/50

(54) **PROCÉDÉ DE TRAITEMENT DE SURFACE D'UN FILM EN MOUVEMENT ET INSTALLATION POUR LA MISE EN OEUVRE DE CE PROCÉDÉ**
VERFAHREN ZUR BEHANDLUNG DER OBERFLÄCHE EINER SICH BEWEGENDEN FOLIE UND EINRICHTUNG ZUR IMPLEMENTIERUNG DIESES VERFAHRENS
METHOD FOR TREATING THE SURFACE OF A MOVING FILM, AND FACILITY FOR IMPLEMENTING SAID METHOD

(30) Priorité: 20.04.2015 FR 1553503
(43) Date de publication de la demande: 03.10.2018
(73) Titulaire: Coating Plasma Innovation, 13710 Fuveau (FR)
(72) Inventeur: GAT, Eric, 13790 Peynier (FR)
(74) Mandataire: Schmidt, Martin Peter
(86) Numéro de dépôt international: PCT/FR2016/050792
(87) Numéro de publication internationale: WO 2016/170242

(56) Documents cités:
- EP-A1- 2 762 609
- FR-A1- 2 816 726
- US-A1- 2003 113 479

## Description

### Domaine technique de l'invention

L'invention concerne un procédé de traitement de surface d'un substrat en mouvement. Elle vise plus précisément un procédé dans lequel le substrat est soumis à un plasma généré dans un mélange gazeux, ce qui conduit à la modification de l'état de surface de ce substrat et/ou à la formation d'un dépôt sur la surface précitée. L'invention concerne en particulier un tel procédé, qui peut être mis en oeuvre à une pression proche de la pression atmosphérique, et qui est approprié pour le traitement de surface continu de films polymère en bobines (procédé de type « roll-to-roll »).

### Etat de la technique

On connait déjà des procédés, visant à modifier et à améliorer les propriétés de surface d'un substrat au moyen d'un plasma. De telles propriétés d'intérêt peuvent être, par exemple, l'énergie de surface ou encore les propriétés d'adhésion de ce substrat. Les substrats visés par l'invention peuvent être notamment des isolants tels que des films polymères, ou encore des films métalliques.

Selon ces procédés connus, en vue du dépôt d'une couche solide mince sur la surface d'un substrat, cette surface est soumise à un plasma créé par une décharge électrique dans un gaz et, simultanément ou postérieurement, le substrat ainsi traité est exposé à un mélange gazeux qui contient un composé gazeux actif, susceptible d'induire le dépôt de ce film solide mince.

Il est également connu de mettre en oeuvre de manière continue des procédés de traitement d'un substrat au moyen d'une décharge électrique dans un mélange gazeux, dans lesquels le substrat est mis en mouvement à des vitesses comprises entre environ dix et plusieurs centaines de mètres par minute, typiquement au sein d'une chambre. Cette dernière contient, outre les électrodes nécessaires à la création de la décharge, un dispositif d'injection du mélange gazeux actif, ainsi que des moyens d'évacuation des effluents gazeux.

US-B-8 851 012 décrit un procédé de traitement de la surface d'un substrat, utilisant une tête équipée d'une première électrode, ainsi que d'un canal central permettant d'alimenter un polymère ou un gaz vecteur, via des canaux auxiliaires. Ce document enseigne certaines plages dimensionnelles, notamment quant à la distance entre le substrat et les organes d'injection des différents composés gazeux. Ce document prévoit une séparation spatiale entre l'injection d'un gaz vecteur et la diffusion d'un gaz plasmagène.

EP-A-2 762 609 a pour objet un procédé de traitement de surface d'un substrat en mouvement, dans lequel on introduit un gaz inerte et un mélange gazeux actif vers un support, puis on active le gaz réactif et on traite la surface du substrat précité. On évacue ensuite l'atmosphère gazeuse, laquelle comprend une fraction du gaz inerte et du mélange gazeux actif.

US 2003/113479 divulgue un appareil de traitement par plasma, comprenant deux électrodes opposées définissant un espace de décharge, ainsi que des moyens de fourniture d'un gaz réactif et d'un gaz inerte vers cet espace de décharge. Le gaz réactif est excité dans cet espace de décharge par application d'une tension, mais n'est pas mis en contact direct avec la surface de décharge des deux électrodes précitées.

FR 2 816 726 A décrit un procédé du type ci-dessus, lequel est mis en oeuvre au moyen d'une installation comprenant une chambre de réception des électrodes. Cette installation est en outre munie d'unités auxiliaires, permettant d'éviter respectivement l'entrée d'air dans la chambre, ainsi que la sortie du mélange gazeux hors de cette chambre. Chaque unité auxiliaire comprend une fente d'injection d'azote permettant la création, en service, de "couteaux" gazeux. Des moyens sont en outre prévus afin de réguler les débits gazeux, de façon à maintenir une différence de pressions proche de zéro entre l'intérieur de la chambre et l'atmosphère extérieure.

Cependant, le procédé décrit dans FR-A-2 816 726 implique certains inconvénients. Tout d'abord il fait appel à des couteaux gazeux qui impliquent une consommation élevée d'azote. De plus, le pilotage des conditions à l'intérieur de la chambre est relativement complexe à mettre en oeuvre. En particulier, la pression à l'intérieur de la chambre est difficile à réguler de manière stable et reproductible. En d'autres termes, cette pression est sujette à des variations sensibles, qui ne sont pas favorables au bon pilotage de ce procédé. Enfin l'installation décrite dans FR-A-2 816 726, permettant la mise en oeuvre de ce procédé, est relativement lourde et onéreuse.

Compte tenu de ce qui précède, un objectif de la présente invention est de remédier, au moins partiellement, aux inconvénients de l'art antérieur évoqués ci-dessus.

Un autre objectif de l'invention est de proposer un procédé qui, tout en assurant un traitement de surface fiable d'un substrat, notamment de type "roll to roll", à une pression proche de la pression atmosphérique, permet de réduire significativement la quantité de gaz inerte consommée, par rapport à l'art antérieur.

Un autre objectif de l'invention est de proposer un tel procédé, qui est commode à piloter et qui peut être mis en oeuvre à l'aide d'une installation relativement simple.

### Objet de l'invention

Selon l'invention, les objectifs ci-dessus sont atteints au moyen d'un procédé de traitement de surface d'un substrat en mouvement, dans une installation comprenant
- une enceinte;
- un support pour le substrat, reçu dans ladite enceinte;
- une contre électrode;
   - au moins une tête définissant un volume intérieur ouvert en direction du support, ladite tête étant pourvue
   - d'au moins une électrode adaptée pour coopérer avec ladite contre électrode pour créer une décharge électrique;
   - de moyens de diffusion pour la diffusion d'un gaz inerte vers ledit support; et
   - de moyens d'injection, distincts des moyens de diffusion, pour l'injection d'au moins un mélange gazeux actif vers ledit support, ce mélange gazeux actif comprenant un gaz réactif propre à être activé par ladite décharge électrique ;
   - les moyens d'injection étant placés entre les moyens de diffusion et le support ;
- la tête et le support définissant au moins une sortie pour le gaz inerte et/ou le mélange gazeux actif,
procédé dans lequel
i. on introduit à la fois le gaz inerte et le mélange gazeux actif vers ledit support, de manière à plaquer le mélange gazeux actif contre ledit support;
ii. on active le gaz réactif dans ladite décharge électrique et on traite la surface dudit substrat en mouvement ;
iii. on évacue, par ladite sortie, l'atmosphère gazeuse du volume intérieur (V), ladite atmosphère gazeuse comprenant une fraction du gaz inerte et du mélange gazeux actif ;
iv. on règle la section efficace de la sortie et/ou on règle le débit total du gaz inerte et du mélange gazeux actif, de sorte que la différence de pressions (P1-P0 ; P2-P0) entre le volume intérieur de chaque tête et le volume intérieur de l'enceinte est supérieure à 10 Pascal,
sachant que les étapes (i) à (iv) ne sont pas nécessairement chronologiques.

Le procédé selon l'invention permet de s'affranchir de l'utilisation d'unités d'entrée et de sortie associées à des couteaux d'azote, telles que connues de FR-A-2 816 726. Par conséquent, ce procédé autorise une réduction substantielle de la consommation de gaz inerte, par rapport à cet état de la technique. La structure globale de l'installation, permettant la mise en oeuvre du procédé de l'invention, s'en trouve nettement simplifiée.

De plus, la Demanderesse a découvert que, de façon surprenante, le fait d'injecter le mélange gazeux actif au voisinage du substrat, tout en diffusant le gaz inerte depuis l'intérieur même de la chambre, assure un traitement plasma de qualité satisfaisante. En effet, ceci permet d'éviter toute fuite substantielle de ce mélange gazeux actif hors de la chambre. En d'autres termes, sensiblement la totalité du gaz réactif est déposée sur les surfaces exposées au plasma.

Sans vouloir être lié par cette théorie, les inventeurs pensent que ceci peut être dû au fait que le mélange gazeux est repoussé, ou plaqué, contre le substrat, sous l'effet du gaz inerte. Ce dernier évite par ailleurs toute entrée significative à l'intérieur de la zone de décharge définie par les électrodes, d'air éventuellement chargé d'impuretés telles que des poussières, emporté par le substrat en déplacement.

Cet effet de plaquage du mélange gazeux, par le gaz inerte, est également assuré par la mise en légère surpression de la tête par rapport au reste de l'enceinte. La différence de pressions entre les volumes intérieurs de cette tête et de cette enceinte est typiquement supérieure à 10 Pascal (Pa). De façon avantageuse, cette différence est supérieure à 20 Pascal, notamment 50 Pascal.

On notera en outre que la présente invention est avantageuse en termes de sécurité et de souplesse, par rapport à la solution décrite dans FR-A-2 816 726. En effet, dans cette solution antérieure, l'enceinte de traitement ne peut être placée à une valeur de surpression élevée, afin d'éviter toute fuite significative d'azote dans l'atmosphère ambiante. De ce fait, il existe un risque que cette surpression soit faible, voire qu'il y ait une inversion de pressions susceptible d'induire une arrivée intempestive d'oxygène dans l'enceinte.

La valeur de la surpression, utilisée dans la présente invention, peut tout d'abord être modifiée en réglant la section efficace de la sortie. Ceci est typiquement obtenu en agissant sur la position de la tête par rapport au support. Dans ce cas, si on éloigne la tête par rapport au support, ceci tend à réduire la valeur de cette surpression alors que, si on rapproche la tête, la valeur de cette surpression est augmentée.

En complément ou en substitution, on peut également agir sur la valeur du débit gazeux global, formé par la somme des débits respectifs du gaz inerte et du mélange gazeux actif. Dans ce cas, si on augmente ce débit global, ceci a tendance à augmenter la valeur de cette surpression. En revanche, une diminution de ce débit global s'accompagne d'une réduction de cette valeur de surpression.

Selon d'autres caractéristiques de l'invention :
(a) on règle la section efficace de la sortie et/ou on règle le débit total du gaz inerte et du mélange gazeux actif, de sorte que la différence de pressions entre le volume intérieur de chaque tête et le volume intérieur de l'enceinte est supérieure à 20 Pascal, en particulier supérieure à 50 Pascal ;
(b) on injecte le gaz inerte à un débit compris entre 1 et 10 litres par mètre carré, notamment entre 2,5 et 5 litres par mètre carré ;
(c) on injecte le mélange gazeux actif à un débit compris entre 1 et 100 millilitres par mètre carré, notamment entre 5 et 50 millilitres par mètre carré ;
(d) le rapport entre le débit du gaz inerte et le débit du mélange gazeux actif est compris entre 100 et 10 000, notamment entre 500 et 5 000 ;
(e) on positionne la tête par rapport au support, de sorte que la hauteur de la sortie est comprise entre 0,5 et 2,5 millimètres, notamment entre 0,8 et 1,2 millimètres ;
(f) on injecte le gaz inerte en au moins un point d'injection de gaz inerte, la distance entre chaque point d'injection de gaz inerte et le support étant comprise entre 50 et 150 millimètres, notamment entre 75 et 125 millimètres ;
(g) on injecte le mélange gazeux actif en au moins un point d'injection de mélange gazeux, la distance entre chaque point d'injection mélange gazeux et le support étant comprise entre 0,5 et 3,0 millimètres, notamment entre 1,0 et 1,5 millimètres ;
(h) on mesure la concentration en oxygène dans le volume intérieur de chaque tête et on règle la section efficace de la sortie et/ou on règle le débit total du gaz inerte et du mélange gazeux actif, si cette concentration mesurée se situe en dehors d'une plage prédéterminée ;
(i) le mélange gazeux actif comprend, outre le gaz réactif, un gaz vecteur ;
(j) on utilise un gaz inerte d'un premier type, notamment de l'azote, et un gaz vecteur d'un type différent, notamment de l'hélium ;
(j') on choisit un gaz vecteur qui présente des propriétés plasmagènes améliorées par rapport à l'azote, comme un gaz noble tel que l'hélium ou l'argon.
(k) le gaz réactif comprend au moins un monomère et/ou au moins un dopant ;
(l) on injecte un premier mélange gazeux actif comprenant de l'hydrogène en tant que gaz réactif, dans au moins un organe d'injection amont, afin d'éliminer au moins une partie de la couche limite d'oxygène présente à la surface du substrat, puis on injecte un second mélange gazeux actif différent du premier mélange gazeux actif, dans au moins un organe d'injection aval, à la surface du substrat libérée d'au moins une partie de ladite couche d'oxygène ;
(m) le ou chaque organe d'injection amont est prévu dans une chambre supplémentaire amont, distincte de l'enceinte, alors que le ou chaque organe d'injection aval est prévu dans l'enceinte ;
(n) le ou chaque organe d'injection amont est prévu dans une première tête, ou tête amont, de l'enceinte, alors que le ou chaque organe d'injection aval est prévu dans une seconde tête, ou tête aval, de l'enceinte ;
(o) le ou chaque organe d'injection amont, ainsi le ou chaque organe d'injection aval, sont prévus dans une unique tête ;
(p) on fait passer le substrat dans une chambre auxiliaire placée en amont de l'enceinte, et on presse ce substrat au moyen d'au moins un rouleau reçu dans cette chambre auxiliaire, afin d'éliminer au moins partiellement la couche d'air présente à la surface du substrat ;
(q) on met en dépression le volume intérieur de cette chambre auxiliaire.

Ces caractéristiques additionnelles (a) à (q) peuvent être mises en oeuvre individuellement ou en combinaisons quelconques.

Les objectifs ci-dessus sont également atteints au moyen d'une installation pour la mise en oeuvre d'un procédé tel que ci-dessus, comprenant
- une enceinte;
- un support pour le substrat, reçu dans ladite enceinte;
- une contre électrode;
- au moins une tête définissant un volume intérieur ouvert en direction du support, ladite tête étant pourvue
   - d'au moins une électrode adaptée pour coopérer avec ladite contre électrode pour créer une décharge électrique;
   - de moyens de diffusion pour la diffusion d'un gaz inerte vers ledit support; et
   - de moyens d'injection, distincts des moyens de diffusion, pour l'injection d'au moins un mélange gazeux actif vers ledit support, ce mélange gazeux actif comprenant un gaz réactif propre à être activé par ladite décharge électrique ;
   - les moyens d'injection étant placés entre les moyens de diffusion et le support
   - la tête et le support définissant au moins une sortie pour le gaz inerte et/ou le mélange gazeux actif,
cette installation comprenant en outre des moyens de réglage de la section efficace de la sortie et/ou des moyens de réglage du débit total du gaz inerte et du mélange gazeux actif.

Selon une caractéristique avantageuse, l'installation comprend en outre une chambre auxiliaire, placée en amont de l'enceinte, ladite chambre auxiliaire étant munie d'au moins un rouleau de pressage adapté pour éliminer au moins partiellement la couche d'air présente à la surface du substrat.

### Description des figures

L'invention va être décrite ci-après, en référence aux dessins annexés, donnés uniquement à titre d'exemples non limitatifs, dans lesquels:
La figure 1 est une vue de face, illustrant une installation permettant la mise en oeuvre d'un procédé de traitement de surface conforme à l'invention.
La figure 2 est une vue en perspective, illustrant une enceinte appartenant à l'installation de la figure 1.
La figure 3 est une vue en perspective, illustrant à plus grande échelle une tête appartenant à l'installation de la figure 1, la paroi avant de cette tête étant omise.
La figure 4 est une vue de face illustrant la tête de la figure 3.
La figure 5 est une vue de face illustrant un tube qui appartient à la tête de la figure 3.
Les figures 6 et 7 sont des vues à plus grande échelle, illustrant les détails VI et VII sur la figure 5.
La figure 8 est une vue de face, illustrant à encore plus grande échelle deux électrodes et un tube qui appartiennent à la tête de la figure 3.
La figure 9 est une vue de face, illustrant une installation permettant la mise en oeuvre d'une variante de réalisation du procédé conforme à l'invention.
Les figures 10 et 11 sont des vues schématiques de face, analogues à la figure 9, illustrant deux variantes de mise en oeuvre du procédé conforme à l'invention.
La figure 12 est une vue de face, analogue à la figure 9, illustrant une installation permettant la mise en oeuvre d'une variante supplémentaire de réalisation du procédé conforme à l'invention.

Les références numériques suivantes sont utilisées dans la présente description:

| | |
|---|---|
| 7, 7', 7" Tubes | I30 Largeur de 30 |
| L7 Longueur de 7 | V Volume intérieur de 30 |
| D7 Diamètre de 7 | E Entrée |
| R7 Direction de rotation of 7 | S Sortie |
| d7 Distance entre 7 et S | 40 Partie supérieure de 30 |
| 8, 8', 8" Electrodes | 42 Diffuseurs |
| L8 Longueur de 8 | 50 Partie inférieure de 30 |
| l8 Largeur de 8 | 60 Filtre |
| d8 Distance entre 8 et S | 71 Orifices de 7 |
| 10 Enceinte | 72 Orifices de 7 |
| l10 Largeur de 10 | L71 Longueur de 71 |
| L10 Longueur de 10 | 76 Bride |
| 11 Paroi supérieure de 10 | 78 Chape |
| 12 Paroi avant de 10 | d78 Distance entre 7 et 8 |
| 13 Paroi arrière de 10 | 90 Source d'azote |
| 14 Paroi latérale de 10 | 91 Ligne amont |
| 15 Paroi latérale de 10 | 92 Ligne aval |
| 16 Rails | 94 Capteur |
| 17 Conduite | 96 Contrôleur |
| 18 Fenêtre | 97 Ligne |
| 19 Porte | 98 Ligne |
| 20 Tambour | 110 Enceinte |
| R20 Rotation de 20 | 116, 116', 116" Rails |
| SUB Substrat | 130₁ à 130ₙ Têtes |
| 22 Nip | 210 Enceinte |
| 30 Tête | 221 Chambre préliminaire |
| 31 Couvercle | E210 Entrée de 210 |
| 32 Paroi avant de 30 | S210 Sortie de 210 |
| 33 Paroi arrière de 30 | E221 Entrée de 221 |
| 34 Paroi latérale de 30 | 222, 222' Rouleaux |
| 35 Paroi latérale de 30 | 224 Dispositif d'aspiration |
| L30 Longueur de 30 | |

### Description détaillée

L'installation de l'invention comprend tout d'abord un corps ou enceinte 10, qui possède une paroi supérieure 11 et des parois périphériques, formées par des parois avant 12 et arrière 13 parallèles, ainsi que des parois latérales parallèles 14 et 15. A titre d'exemple, sa longueur L10, à savoir la distance entre les parois 12 et 13, est comprise entre 1 000 mm et 2 000 mm. A titre d'exemple, sa largeur l10, à savoir la distance entre les parois 14 et 15, est comprise entre 1 000 mm et 2 000 mm. L'enceinte est également munie d'une conduite 17, de type connu en soi, afin d'aspirer un excès de gaz hors du volume intérieur de l'enceinte 10.

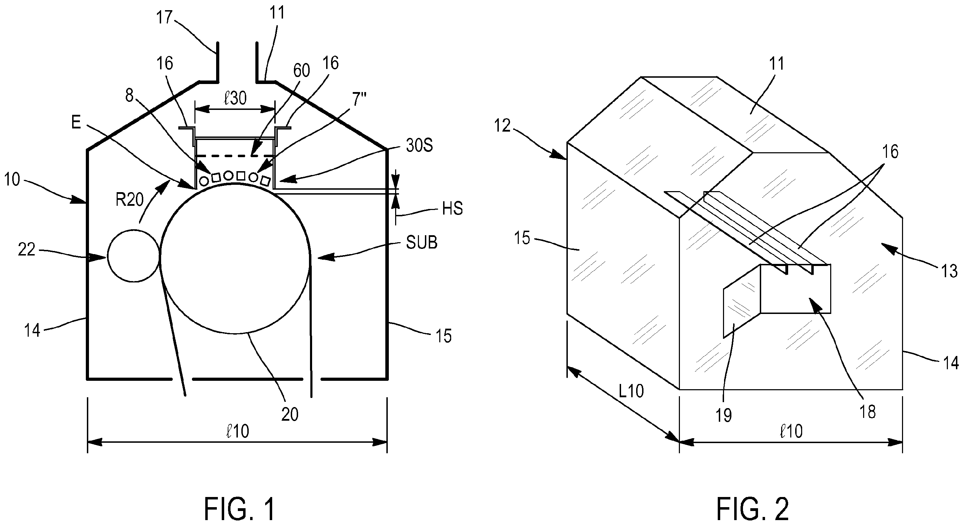

Comme cela est montré de façon schématique sur la figure 2, qui illustre uniquement l'enceinte depuis l'arrière, des rails 16 s'étendent entre les parois 12 et 13. Ils sont fixés sur ces parois, par tout moyen approprié. La fonction de ces rails sera décrite dans ce qui suit. Une fenêtre 18 et une porte 19 sont prévues sur la paroi arrière 13, afin d'autoriser l'accès aux rails 16.

L'installation comprend en outre un tambour 20 qui est mis en rotation, en service, selon la direction matérialisée par la flèche R20. Ce tambour forme un support pour le substrat SUB destiné à être traité conformément à l'invention. Dans le présent mode de réalisation, ce tambour assure une fonction supplémentaire de contre électrode, laquelle coopère avec des électrodes qui seront décrites dans ce qui suit. Cependant, cette contre électrode peut être formée par un autre composant de l'installation. A titre d'exemple, le substrat est fait de polypropylène, alors que son épaisseur est comprise entre 20 et 100 micromètres.

Dans sa partie amont, en référence au déplacement du substrat, le tambour est associé à un rouleau presseur 22 (appelé par l'homme du métier aussi "nip"), de type connu en soi. Ce rouleau secondaire 22 permet de presser le substrat contre le tambour 20, de manière à éviter la formation d'une couche d'air entre ce substrat et ce tambour. Ceci permet d'éviter tout défaut local de traitement sur le substrat.

Au-dessus du tambour 20, une tête 30 est prévue, laquelle est équipée de tubes et d'électrodes, comme cela sera expliqué dans ce qui suit. La largeur l30 de la tête 30 est nettement inférieure à celle l10 de l'enceinte. Cette tête s'étend selon un arc du cercle défini par le tambour 20, de manière approximativement centrale.

La longueur L30 de cette tête est par exemple légèrement inférieure à celle L10, en particulier si le substrat couvre sensiblement l'intégralité de la longueur du tambour. Cependant, si ce substrat couvre seulement une partie de ce tambour, la longueur L30 de cette tête peut être nettement inférieure à L10, de sorte que la tête ne fait pas saillie longitudinalement au-delà du substrat.

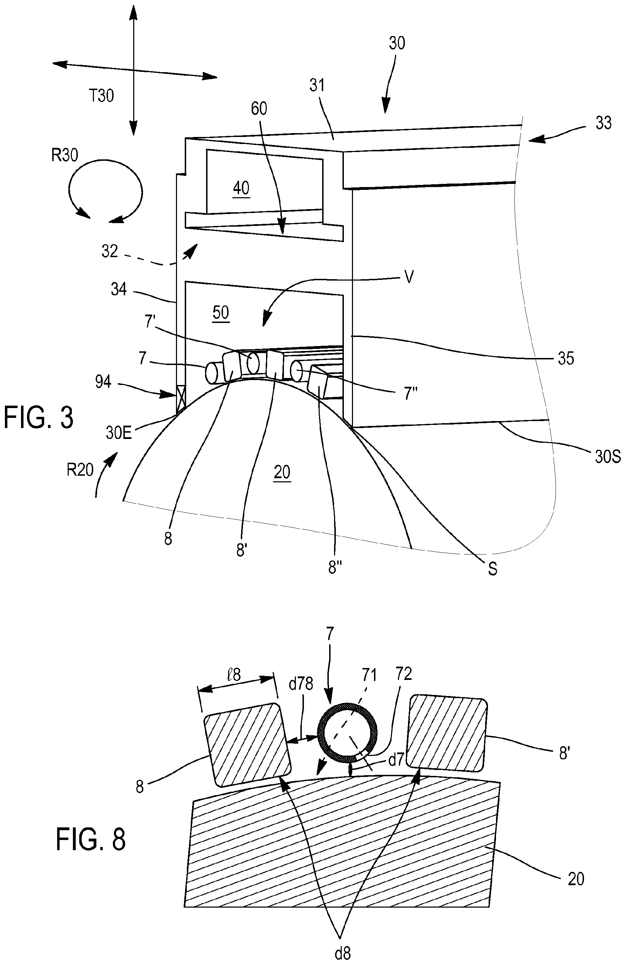

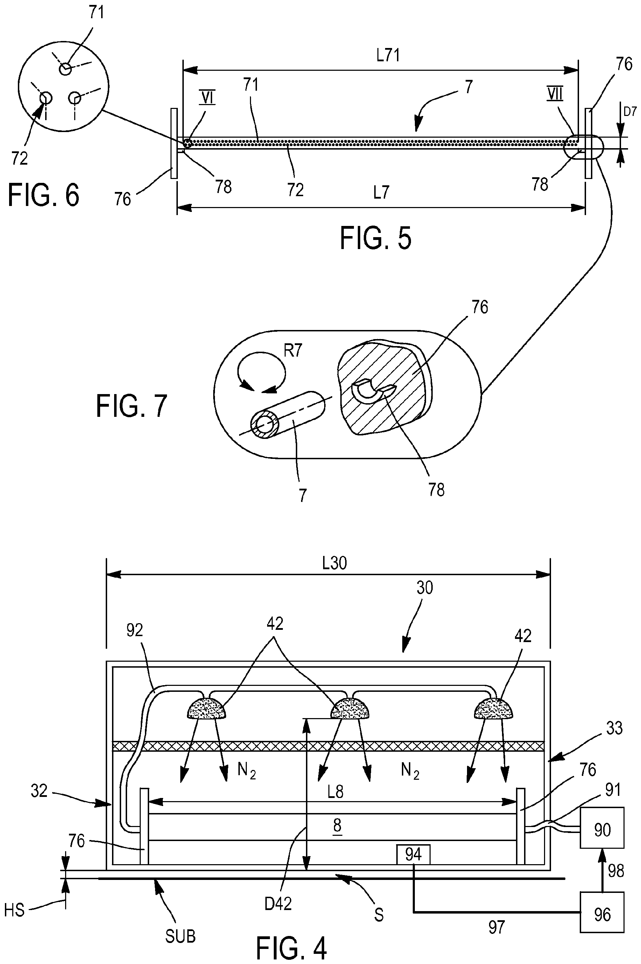

En référence aux figures 3 et 4, la tête 30 comprend un couvercle 31 et des parois périphériques, formées par des parois parallèles avant et arrière 32 et 33, ainsi que par des parois latérales 34 et 35. A titre d'exemple, elle est réalisée en PET (polyéthylène téréphtalate). A des fins de clarté, la paroi avant 32 est omise sur la figure 3, alors qu'elle est représentée sur la figure 4.

Les parties supérieures des parois latérales coopèrent avec les rails 16, en vue de la fixation de la tête. D'une façon préférée, cette fixation permet de monter la tête 30 sur les rails 16 d'une façon amovible, en particulier par encliquetage.

Cette tête 30 définit un volume intérieur V qui est ouvert en direction du tambour 20. Ce dernier définit, avec chaque bord libre 30E et 30S de la tête, deux espaces E et S formant respectivement une entrée E et une sortie S. L'entrée E correspond au côté amont, par lequel est admis le substrat, alors que la sortie S correspond au côté aval. Comme cela sera décrit plus en détail dans ce qui suit, cette sortie assure l'évacuation en continu de l'atmosphère gazeuse initialement présente dans le volume V.

La hauteur de chaque espace E et S, à savoir la distance entre chaque bord libre 30E, 30S et le support, est typiquement comprise entre 0,5 et 2,5 millimètres, de préférence comprise entre 0,8 et 1,2 millimètres. Si cette hauteur est trop faible, la sortie de gaz inerte est insuffisante et l'effet de lamination n'est pas satisfaisant. En revanche, si cette hauteur est trop élevée, il n'y a pas une valeur de surpression suffisante entre la tête et le reste de l'enceinte. Sur la figure 1, on a représenté la hauteur HS, la section efficace de la sortie S étant définie par le produit (HS * L30) de la hauteur HS par la longueur L30.

La valeur de la hauteur de chaque espace E et S peut être modifiée, en déplaçant la tête 30 par rapport au tambour 20. Cette possibilité est montrée par la flèche T30 qui souligne le mouvement de translation de la tête par rapport au support, ainsi que par la flèche R30 qui souligne le mouvement de rotation de cette tête par rapport à ce support. Comme cela sera explicité dans ce qui suit, la modification de la position relative de la tête et du support permet de modifier la section efficace de la sortie.

La tête est divisée en deux parties par un filtre 60, dénommées ci-après parties supérieure 40 et inférieure 50. Dans sa partie supérieure 40, la tête est munie de moyens de diffusion, reliés à une source de gaz inerte tel de l'azote, comme cela sera décrit dans ce qui suit. Dans l'exemple illustré ces moyens de diffusion sont formés de plusieurs diffuseurs 42, de tout type approprié.

On note, sur la figure 4, D42 la distance d'injection, à savoir la distance entre le débouché des diffuseurs 42 et le substrat SUB. Ces diffuseurs, qui ont une pluralité de trous de diffusion, sont formés de façon régulière à la surface de la tête. Ce filtre, qui est connu en soi, possède entre autres la fonction d'améliorer l'homogénéité de l'azote envoyé vers la partie inférieure 50 de la tête.

La partie inférieure 50 de la tête reçoit tout d'abord des organes d'injection d'un mélange gazeux actif. Dans l'exemple illustré, ces organes sont des tubes d'injection 7, 7' et 7", prévus au nombre de trois. A titre de variante, on peut prévoir un nombre différent d'organes d'injection et/ou on peut prévoir que ces organes d'injection sont structurellement différents d'un tube, à savoir qu'ils sont formés par exemple par un barreau perforé.

La partie inférieure 50 de la tête reçoit en outre trois électrodes 8, 8' et 8", qui sont agencées alternativement par rapport aux tubes 7, 7' et 7", selon le sens de rotation du tambour. En d'autres termes, le tube 7 amont est placé entre la paroi latérale 34 et l'électrode amont 8, alors que les tubes 7' et 7" sont placés entre des électrodes adjacentes, à savoir 8, 8' et 8', 8".

Selon d'autres variantes non représentées, l'invention englobe d'autres agencements mutuels de tubes et d'électrodes. A titre d'exemple, deux électrodes peuvent être placées côte à côte, ou bien un premier tube peut être disposé entre une électrode amont 8" et la paroi latérale 35. Deux tubes peuvent aussi être placés côte à côte, en étant disposés entre deux électrodes ou entre une paroi latérale et une électrode.

A titre d'exemple, les tubes sont réalisés en métal, ou en matière plastique, comme en un matériau polymère, en particulier en PET. Ils sont connectés à une source non représentée d'un mélange gazeux actif, en vue de réaliser un traitement plasma du substrat SUB.

La structure du tube 7 va maintenant être décrite, sachant que les autres tubes 7' et 7" ont la même structure. Comme le montre la figure 5, le tube 7 est allongé et présente une section transversale circulaire. Sa longueur L7, qui est légèrement inférieure à celle L30 de la tête, est comprise à titre d'exemple entre 20 et 2 000 millimètres. Son diamètre externe D7 est par exemple compris entre 10 et 20 millimètres.

Le tube 7 est percé de deux rangées parallèles 71 et 72 d'orifices d'injection, réalisés par tout procédé approprié. Ces orifices s'étendent selon une longueur L71, qui représente une partie substantielle de la longueur totale de ces tubes.

Dans l'exemple, il y a deux rangées d'orifices, lesquelles sont mutuellement décalées. Ceci permet de réduire les effets de la turbulence d'injection, tout en améliorant l'homogénéité du dépôt final. Ceci évite tout dépôt intempestif d'un film parasite sur les électrodes elles-mêmes, qui serait de nature à réduire la vitesse de dépôt sur le substrat et serait préjudiciable à la qualité de ce dépôt.

Les deux extrémités de chaque tube sont montées sur des brides 76, situées à proximité respectivement des parois avant et arrière. Selon un mode de réalisation avantageux, au moins l'une de ces extrémités est fixée sur une chape 78, supportée par une bride respective, qui a la forme d'une partie de cylindre (voir figure 7).

Par conséquent, ce tube peut être déplacé en rotation autour de son axe longitudinal principal, comme montré par la flèche R7, ce qui permet de faire varier l'angle d'injection du mélange gazeux en direction du substrat. Ceci assure une réduction des effets dus à la turbulence d'injection, comme cela sera expliqué dans ce qui suit.

De plus chaque tube est avantageusement fixé sur la tête de manière amovible, par encliquetage ou analogue. Par conséquent, un tube donné peut être remplacé par un autre tube similaire, en particulier en cas de défaillance. L'expression « tubes différents » signifie qu'au moins un des paramètres suivants varie d'un tube à l'autre :
- Dimension totale du tube
- Dimension des orifices
- Positionnement de ces orifices, en particulier nombre de rangées
- Longueur L71 de la zone perforée.

Avantageusement chaque électrode a une surface extérieure lisse, ce qui évite la création de turbulence dans la zone de formation du plasma. Cette électrode est de préférence réalisée en matériau céramique, ce qui permet de traiter un substrat électriquement conducteur. A titre d'alternative, les électrodes peuvent être réalises en tout autre matériau approprié, comme en matériau métallique.

La structure de l'électrode 8 va maintenant être décrite, sachant que les électrodes 8' et 8" ont la même structure. En référence aux figures 4 et 8, l'électrode 8 est allongée et a une section transversale de forme carrée. Sa longueur L8 est sensiblement égale à celle L7 du tube 7, alors que sa largeur l8 est similaire au diamètre D7 du tube 7, notamment comprise entre 10 et 20 millimètres.

Les deux extrémités de chaque électrode sont fixées sur les brides 76 (figure 4), à proximité des extrémités des tubes. Contrairement aux tubes, ces électrodes ne sont pas montées sur ces brides avec une possibilité de rotation. Les électrodes 8 sont connectées à une source de très haute tension, non représentée.

De plus chaque électrode est avantageusement fixée sur la tête de manière amovible, par tout moyen approprié. Par conséquent, une électrode donnée peut être remplacée par une autre électrode similaire, en particulier en cas de défaillance. Cette électrode peut aussi être remplacée par une autre électrode, de type différent. L'expression « électrodes différentes » signifie qu'au moins un des paramètres suivants varie d'un tube à l'autre :
- Dimension totale de l'électrode
- Matériau de l'électrode
- Forme de de l'électrode.

Comme montré également en figure 4, les électrodes 8 sont connectées à une source commune d'azote 90, via des lignes amont 91. L'azote s'écoule le long de ces électrodes, puis de lignes aval 92 qui débouchent dans chaque diffuseur 42.

De plus un capteur 94, de tout type approprié, est adapté pour mesurer la teneur en oxygène au voisinage des électrodes. Comme montré en figure 3, le capteur est positionné à proximité de l'entrée E. Ce capteur est connecteur à un dispositif de commande 96, via une ligne 97, de manière à commander le débit d'azote grâce à une ligne supplémentaire 98, qui débouche dans la source 90.

La plus petite distance entre les orifices d'injection 71, 72 et le substrat SUB est référencée d7, alors que d8 désigne la plus petite distance entre chaque électrode 8 et le substrat. La distance d8 est par exemple comprise entre 500 et 2 500 micromètres, typiquement entre 500 et 1 500 micromètres, en particulier égale à 1 000 micromètres. Avantageusement la distance d7 est légèrement supérieure à celle d8. De la sorte la tête peut être positionnée par rapport à la contre électrode 20, comme expliqué ci-dessus, sans risque de contact entre les tubes 7 et cette contre électrode.

Chaque tube est disposé sensiblement à équidistance des deux électrodes, entre lesquels il est situé. A titre d'exemple, la plus petite distance d78 entre un tube et une électrode est comprise entre 5 et 10 millimètres. Si la distance d78 est trop faible, un arc électrique risque de se créer. En revanche, si d78 est trop élevée, ceci peut créer un volume mort substantiel, dans lequel du mélange gazeux peut s'écouler.

Différentes possibilités de mise en oeuvre du procédé conforme à l'invention, au moyen de l'installation ci-dessus, vont maintenant être explicitées dans ce qui suit.

Dans une phase préalable, de l'azote est tout d'abord admis dans le volume V par l'intermédiaire des diffuseurs 42. On ne met pas en mouvement le substrat, avant que la concentration en oxygène mesurée par le capteur 94 ne tombe au-dessous d'un seuil donné, par exemple égal à 20 ppm (parties par million). Quand la valeur de cette concentration est appropriée, on déplace alors le substrat grâce au support, alors que du mélange gazeux actif est injecté par les tubes 7, et qu'on génère une décharge par les électrodes 8.

Ce mélange gazeux actif comprend un gaz réactif propre à être activé par la décharge électrique précitée. Ce gaz réactif peut comprendre :
* au moins un composé de type dopant, susceptible de modifier la surface du substrat en vue d'un traitement postérieur, de type greffage ou fonctionnalisation moléculaire. A titre d'exemple, ce dopant peut être :
   - un gaz oxydant, comme O₂, CO₂, N₂O ou l'air
   - un gaz réducteur, comme H₂
   - un hydrocarbure, comme C₂H₂
   - un gaz fluoré, comme CHF₃.
* au moins un composé de type monomère, susceptible de créer une couche de dépôt à la surface du substrat, par polymérisation avec des monomères présents dans le mélange gazeux actif et/ou à la surface du substrat. Cette surface peut avoir fait préalablement l'objet d'une fonctionnalisation moléculaire, telle que définie ci-dessus, ou bien subir postérieurement une telle fonctionnalisation. A titre d'exemple, ce monomère peut être :
   - un organosilicate, comme le TEOS (TétraEthyl Orthosilicate)
   - un organosiloxane non cyclique, comme le HMDSO (Hexaméthyl Di Siloxane)
   - un organosiloxane cyclique, comme l'OCTMS (Octaméthyl Cyclo Tétra Siloxane)
   - un organosilane, comme l'OTES (Tri Ethoxy - N- Octylsilane).

Le gaz réactif peut donc être constitué par le monomère, ou bien par le dopant, ou bien par un mélange entre monomère et dopant. Dans le cas d'un mélange, le rapport entre les fractions volumiques du dopant et du monomère est par exemple compris entre 10 et 30.

Le mélange gazeux peut être constitué par le gaz réactif, à savoir qu'il n'inclut pas de fraction substantielle d'un autre composant. En particulier, le mélange gazeux peut être constitué par un ou plusieurs dopant(s) seul(s), notamment dans le cas où ces derniers se prêtent à une telle utilisation sans danger particulier, comme le N₂O ou le CO₂.

En variante le mélange gazeux peut comprendre, outre le gaz réactif, un gaz vecteur. Ce dernier peut être défini comme un gaz susceptible de transporter le gaz réactif, sans modifier la nature de ce dernier, ni la nature du substrat. Dans ce cas, le rapport entre les fractions volumiques du gaz vecteur et du gaz réactif est par exemple compris entre 10 et 100.

On peut choisir un gaz vecteur, qui est identique au gaz inerte injecté par les diffuseurs 42. Dans ce cas, il peut s'agir typiquement d'azote.

Selon une variante avantageuse, on peut choisir un gaz vecteur qui est différent du gaz inerte. On peut en particulier choisir un gaz vecteur qui présente des propriétés plasmagènes améliorées par rapport à l'azote, comme un gaz noble tel que l'hélium. En effet, étant donné que la quantité de gaz vecteur utilisé est bien moindre que la quantité de gaz inerte, ceci n'engendre pas de surcoût inacceptable.

Une des applications visées par l'invention est le dépôt assisté par plasma. Dans ce cas, on utilise un mélange réactif composé d'au moins un monomère, avantageusement associé à au moins un dopant et à un gaz vecteur. Etant donné que le dopant est injecté en même temps que le monomère, ceci augmente la qualité et l'homogénéité du dépôt, notamment grâce au fait que le rapport entre leurs concentrations est homogène sur la toute surface traitée du substrat.

Une autre des applications visées par l'invention est le greffage assisté par plasma. Dans ce cas, on utilise un mélange réactif composé d'au moins un dopant, associé le cas échéant à un gaz vecteur. Etant donné que le dopant est injecté au plus près du substrat, il présente une homogénéité très satisfaisante à la surface de celui-ci. De plus, on évite toute perte substantielle de dopant, puisque les risques d'entraînement par le gaz inerte sont réduits. Enfin, dans le cas où le dopant est l'acétylène, la formation intempestive de poudre sur les électrodes est fortement diminuée.

Le gaz inerte, injecté en continu par les diffuseurs 42, tend à plaquer sur le substrat le mélange gazeux, lequel est injecté par les tubes 7, à savoir au plus près du substrat. Afin de garantir un effet de placage satisfaisant, on maintient le volume intérieur V de la tête 30 en légère surpression par rapport au reste de l'enceinte 10.

Comme explicité ci-dessus, une valeur appropriée de cette surpression est assurée en modifiant le cas échéant la position de la tête par rapport au support, selon les flèches T30 et/ou R30. Ceci tend à modifier la hauteur de la sortie S et par conséquent sa section efficace, à savoir la section de cette sortie par laquelle peut s'écouler le gaz évacué hors du volume V. En complément ou en substitution, on peut également agir sur la valeur du débit gazeux global, formé par la somme des débits respectifs du gaz inerte et du mélange gazeux actif.

De façon avantageuse, la concentration en oxygène est mesurée en continu par le capteur 94 est mesurée en continu durant le traitement plasma. Si cette concentration excède le seuil précité, le dispositif de commande 90 augmente le débit en azote, afin de diminuer cette concentration en oxygène. On notera en outre que l'écoulement d'azote à travers les électrodes, via les lignes 91, permet d'évacuer la chaleur hors de ces électrodes.

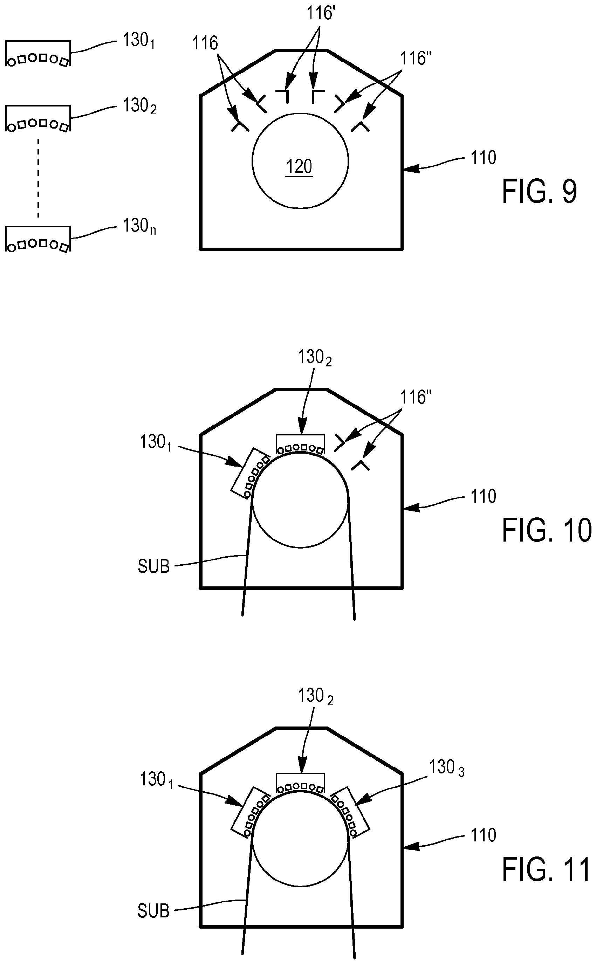

Les figures 9 à 11 illustrent un autre mode de réalisation avantageux de l'invention. Les éléments mécaniques de ces figures 9 à 11, qui sont similaires à ceux du mode de réalisation des figures 1 à 8, y sont affectés des mêmes numéros de référence augmentés de 100.

L'enceinte 110 est équipée de plusieurs paires de rails 116, 116' et 116", qui s'étendent côte à côte selon la direction de déplacement du substrat. En d'autres termes, on retrouve des rails respectivement amont 116, intermédiaires 116' et aval 116". L'accès à ces rails est autorisé par des fenêtres et des portes non représentées, comme décrit précédemment. De plus l'installation comprend plusieurs têtes 130₁ à 130ₙ, qui peuvent être identiques ou différentes, selon la définition donnée ci-dessus.

Selon une première possibilité non représentée, une tête unique peut être positionnée sur une première paire de rails, en particulier la paire intermédiaire 116'. Un premier type de traitement du substrat peut être réalisé, comme décrit ci-dessus.

La figure 10 montre une autre possibilité dans laquelle deux têtes, par exemple celles 130₁ et 130₂, sont placées sur des rails respectifs, par exemple ceux 116 et 116'. Si ces têtes sont identiques, un dépôt plus épais peut être obtenu sans réduire la vitesse du substrat. En revanche, si ces têtes sont différentes, à savoir que leurs tubes sont alimentés avec des mélanges gazeux différents, le dépôt final peut inclure deux couches de natures différentes.

Selon un mode de réalisation avantageux on peut prévoir de réaliser, dans la première tête 130₁, un traitement préliminaire plasma visant à éliminer au moins partiellement la couche d'oxygène limite présente sur le substrat. A cet effet, le mélange gazeux injecté dans cette première tête est par exemple de l'azote, ou bien un mélange d'azote et d'hydrogène. Ceci garantit une réduction significative de la quantité de gaz consommée dans la deuxième tête 130₂, en vue de l'inertage de son volume intérieur. Par conséquent, la quantité totale de gaz consommée pour inerter les deux têtes 130₁ et 130₂ est globalement diminuée.

On notera que le traitement liminaire, décrit au paragraphe ci-dessus, peut également être mis en oeuvre dans le cas où il est prévu une unique tête, comme celle 30 des figures 1 à 8. Dans ce cas l'azote, ou bien le mélange d'azote et d'hydrogène, est injecté dans la partie amont de la tête, par exemple dans le tube 7. Un autre mélange gazeux est alors injecté dans la partie aval de la tête, par exemple dans les tubes 7' et 7".

La figure 11 montre encore une autre possibilité dans laquelle trois têtes, par exemple celles 130₁, 130₂ et 130₃, sont placées sur les trois paires de rails. Si ces têtes sont identiques, un dépôt encore plus épais peut être obtenu sans réduire la vitesse du substrat. En revanche, si deux de ces têtes sont identiques mais que la troisième est différente, le dépôt final peut inclure deux couches de natures différentes, dont l'une est plus épaisse que l'autre. Enfin, si les trois têtes sont différentes les unes des autres, le dépôt final peut inclure trois couches de natures différentes. On peut également prévoir de réaliser, dans la tête amont 130₁, un traitement préliminaire plasma tel que décrit immédiatement ci-dessus.

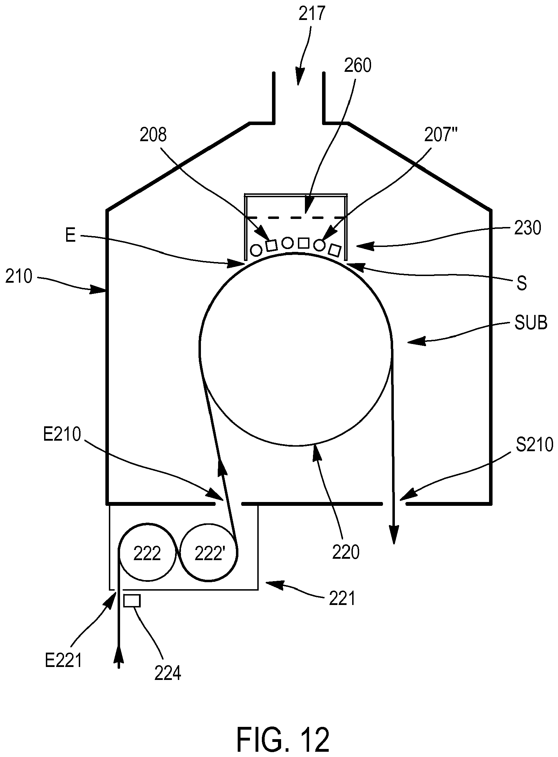

La figure 12 illustre une variante avantageuse de l'invention. Les éléments mécaniques de cette figure 12, qui sont similaires à ceux du premier mode de réalisation des figures 1 à 8, y sont affectés des mêmes numéros de référence augmentés de 200.

L'enceinte 210 est sensiblement fermée et possède trois ouvertures, à savoir celle définie par la conduite d'évacuation 217, ainsi que deux fentes. Une fente amont, ou fente d'entrée E210 assure le passage du substrat arrivant dans le volume intérieur de l'enceinte alors qu'une fente aval, ou fente de sortie S210 assure le passage du substrat SUB sortant de ce volume intérieur.

L'installation montrée sur cette figure 12 comprend en outre une chambre supplémentaire, ou chambre préliminaire 221, qui est située en regard de l'entrée E210 et qui reçoit deux rouleaux d'entraînement 222 et 222'. Cette chambre préliminaire 221 possède sa propre fente d'entrée E221, qui autorise l'arrivée du substrat. La sortie de cette chambre 221 est confondue avec l'entrée E210 de l'enceinte principale.

La chambre préliminaire peut être liée de manière amovible à l'enceinte principale, grâce à tout moyen approprié. En service, le substrat est compressé entre les rouleaux 222 et 222', ce qui permet d'éliminer sensiblement la couche d'air potentiellement présente sur les deux faces opposées du substrat.

Dans l'exemple illustré, l'installation comprend une tête unique 230. En variante, plusieurs têtes peuvent être prévues, comme dans l'exemple des figures 9 à 11. A cet égard, le fait de prévoir une chambre préliminaire 221 séparée peut permettre d'éviter l'utilisation du rouleau 22 de la figure 1. Par conséquent, une portion angulaire plus importante du tambour 220 est accessible, en vue notamment de son association avec plusieurs têtes.

De façon avantageuse, on peut prévoir un dispositif d'aspiration 224, placé au voisinage de l'entrée E221. En service, on peut avantageusement activer ce dispositif 224, de façon à placer le volume intérieur de la chambre 221 en légère dépression par rapport au volume intérieur de l'enceinte 210. A titre indicatif, la différence de pressions entre l'enceinte 210 et la chambre 221 est typiquement comprise entre 10 et 100 Pascal, notamment entre 20 et 50 Pascal. Ceci permet d'améliorer l'élimination de la couche d'air entre les rouleaux 222 et 222'.

A titre de variante non représentée, on peut actionner le dispositif d'aspiration 224, tout en injectant un gaz d'inertage, tel de l'azote. De la sorte, le volume intérieur de la chambre 221 n'est pas mis en dépression. Ceci évite de faire rentrer une quantité significative d'air dans la chambre 221, via l'entrée E221.

A titre de variante supplémentaire, également non représentée, on peut réaliser dans la chambre 221 un traitement préliminaire plasma, tel que celui décrit en référence à la figure 10. Ceci permet d'éliminer encore plus efficacement tout ou partie de la couche d'oxygène limite présente sur le substrat.

### Exemples

L'invention est illustrée ci-dessous par des exemples qui cependant n'en limitent pas la portée. Ces exemples portent sur deux types de traitements plasma.

### Exemple 1

On utilise une installation telle que celle décrite aux figures 1 à 9. L'enceinte possède un volume global de 1,15 m³, et la tête possède un volume de 0,02 m³. On utilise trois tubes dont le diamètre est de 15 millimètres, trois électrodes dont la largeur est de 15 millimètres, ainsi que huit diffuseurs identiques.

Les distances respectives sont les suivantes :
- d7 = 1,2 millimètre
- l8 = 1,0 millimètre
- d78 = 5,0 millimètres
- D42 = 120 millimètres
- HS = 0,8 millimètre.

On fait défiler, à une vitesse de 10 mètres par minute, un film de PET, dont la largeur est 1 200 millimètres et dont l'épaisseur est de 12 micromètres.

On utilise :
- en tant que monomère, du TEOS (TétraEthyle OrthoSilicate)
- en tant que dopant, du N₂O
- en tant que gaz inerte, de l'azote
- en tant que gaz vecteur, de l'azote.

On vaporise le monomère à une température voisine de 60°C au moyen d'une cellule de type CEM (Controlled Evaporator Mixer) dans une décharge électrique de type DBD (Dielectric Barrier Discharge).

* Dans une première mise en oeuvre, conforme à l'invention, on injecte le mélange gazeux réactif, constitué du monomère, du dopant et du gaz vecteur, dans les tubes 7 à des débits respectifs de 30 grammes/heure, 3 litres/minute et 9 litres/minute. On injecte en outre l'azote d'inertage à un débit de 300 litres/minute, par les diffuseurs 42.

Cette configuration a conduit à la formation d'un dépôt dont l'énergie de surface mesurée sur la laize présente une homogénéité satisfaisante. Ce dépôt présente une énergie de surface très élevée, mesurée à 105 mN/m selon la norme ASTM D-2578. On note la formation d'une faible quantité de poudre, de couleur claire, sur les électrodes et les parois des tubes.

* On a ensuite réalisé, à titre comparatif, une seconde mise en oeuvre, qui n'est pas conforme à l'invention. A cet effet, le dopant N₂O a été injecté, non pas dans les tubes 7 avec le monomère et le gaz vecteur, mais dans les diffuseurs 42 en mélange avec le gaz inerte. Tous les autres paramètres opératoires étaient par ailleurs inchangés.

Cette configuration a conduit à la formation d'un dépôt dont l'homogénéité est bien moindre. En effet la valeur de l'énergie de surface varie, selon la largeur de la laize, entre 48 et 58 mN/m. On note la formation d'une quantité de poudre nettement plus élevée sur les électrodes et les parois des tubes. De plus, cette poudre est de couleur brune.

### Exemple 2

On utilise une installation telle que celle décrite aux figures 1 à 9. L'enceinte possède un volume global de 1,15 m³, et la tête possède un volume de 0,02 m³. On utilise trois tubes dont le diamètre est de 15 millimètres, trois électrodes dont la largeur est de 15 millimètres, ainsi que huit diffuseurs identiques.

Les distances respectives sont les suivantes :
- d7 = 1,2 millimètre
- l8 = 1,0 millimètre
- d78 = 5,0 millimètres
- D42 = 120 millimètres
- HS = 0,8 millimètre.

On fait défiler, à une vitesse de 100 mètres par minute, un film de PET, dont la largeur est 1 200 millimètres et dont l'épaisseur est de 12 micromètres.

Conformément à un des modes de réalisation de l'invention, le mélange gazeux réactif comprend deux dopants et deux gaz vecteurs. Ce mélange gazeux global est composé de deux mélanges élémentaires, injectés de façon simultanée. On notera que ce mélange gazeux global est dépourvu de monomère.

Le premier mélange élémentaire, injecté dans les trois tubes, comprend 5% d'hydrogène en tant que dopant, ainsi que de l'azote en tant que gaz vecteur. Le débit de ce premier mélange élémentaire est de 2 litres/minute (débit global pour les 3 tubes).

Le second mélange élémentaire, injecté dans les trois tubes, comprend 1% d'acétylène en tant que dopant, ainsi que de l'azote en tant que gaz vecteur. Le débit de ce second mélange élémentaire est de 2 litres/minute (débit global pour les 3 tubes).

On injecte en outre l'azote d'inertage à un débit de 480 litres/minute.

On appelle zones de décharge respectivement amont, intermédiaire et aval, les zones adjacentes au substrat et voisines des électrodes respectivement 8, 8' et 8". 40% du mélange gazeux réactif passe dans la zone de décharge amont, 67% de ce mélange passe dans la zone de décharge intermédiaire, et 86% de ce mélange passe dans la zone de décharge aval. Dans ces conditions, seule une très faible fraction du mélange gazeux actif est évacuée à l'extérieur de la tête, sans avoir été mise en contact avec une décharge.

On note donc que le procédé de l'invention permet d'améliorer le pouvoir d'inertage de l'azote et d'accroitre la stabilité du plasma. Les espèces actives (H₂ et C₂H₂) restent confinées dans les zones de décharge de la tête.

Cette configuration permet d'obtenir sur le film traité à 100 mètres/minutes une énergie de surface élevée homogène sur sa laize mesurée à 60 mN/m selon la norme ASTM D-2578.

On a ensuite réalisé, à titre comparatif, une seconde mise en oeuvre, qui n'est pas conforme à l'invention. A cet effet, le mélange réactif global a été injecté non pas dans les tubes 7 mais dans les diffuseurs 42 en mélange avec le gaz inerte (azote).

Cette configuration a conduit à une efficacité de greffage de moindre performance. En effet une énergie de surface élevée homogène sur la laize du film traité, mesurée à 60 mN/m selon la norme ASTM D-2578, n'a pas pu être atteinte à une vitesse de défilement du film PET supérieure à 75 mètres/minute.

## Revendications

1. Procédé de traitement de surface d'un substrat (SUB) en mouvement, dans une installation comprenant
- une enceinte (10; 110; 210);
- un support (20; 120; 220) pour le substrat, reçu dans ladite enceinte;
- une contre électrode (20; 120; 220);
- au moins une tête (30; 130₁-130ₙ; 230), définissant un volume intérieur (V) ouvert en direction du support, ladite tête étant pourvue
- d'au moins une électrode (8, 8', 8") adaptée pour coopérer avec ladite contre électrode pour créer une décharge électrique;
- de moyens de diffusion (42), pour la diffusion d'un gaz inerte vers ledit support; et
- de moyens d'injection (7, 7', 7"), distincts des moyens de diffusion, pour l'injection d'au moins un mélange gazeux actif vers ledit support, ce mélange gazeux actif comprenant un gaz réactif propre à être activé par ladite décharge électrique ;
- les moyens d'injection étant placés entre les moyens de diffusion et le support ;
procédé dans lequel
(i) on introduit à la fois le gaz inerte et le mélange gazeux actif vers ledit support, de manière à plaquer le mélange gazeux actif contre ledit support;
(ii) on active le gaz réactif dans ladite décharge électrique et on traite la surface dudit substrat en mouvement ;
(iii) on évacue, par ladite sortie (S), l'atmosphère gazeuse du volume intérieur (V), ladite atmosphère gazeuse comprenant une fraction du gaz inerte et du mélange gazeux actif ;
**caractérisé en ce que** la tête et le support définissent au moins une sortie (S) pour le gaz inerte et/ou le mélange gazeux actif et **en ce que**
(iv) on règle la section efficace de la sortie (S) et/ou on règle le débit total du gaz inerte et du mélange gazeux actif, de sorte que la différence de pressions entre le volume intérieur (V) de chaque tête et le volume intérieur de l'enceinte est supérieure à 10 Pascal, sachant que les étapes (i) à (iv) ne sont pas nécessairement chronologiques.

2. Procédé selon la revendication 1, dans lequel on règle la section efficace de la sortie et/ou on règle le débit total du gaz inerte et du mélange gazeux actif, de sorte que la différence de pressions entre le volume intérieur de chaque tête et le volume intérieur de l'enceinte est supérieure à 20 Pascal, en particulier supérieure à 50 Pascal.

3. Procédé selon la revendication 1 ou 2, dans lequel on mesure la concentration en oxygène dans le volume intérieur de chaque tête et on règle la section efficace de la sortie et/ou on règle le débit total du gaz inerte et du mélange gazeux actif, si cette concentration mesurée se situe en dehors d'une plage prédéterminée.

4. Procédé selon l'une des revendications précédentes, dans lequel le mélange gazeux actif comprend, outre le gaz réactif, un gaz vecteur.

5. Procédé selon la revendication 4, dans lequel on utilise un gaz inerte d'un premier type, notamment de l'azote, et un gaz vecteur d'un type différent, notamment de l'hélium.

6. Procédé selon la revendication 5, dans lequel on choisit un gaz vecteur qui présente des propriétés plasmagènes améliorées par rapport à l'azote, comme un gaz noble tel que l'hélium ou l'argon.

7. Procédé selon l'une des revendications précédentes, dans lequel le gaz réactif comprend au moins un monomère et/ou au moins un dopant.

8. Procédé selon l'une des revendications précédentes, dans lequel on injecte un premier mélange gazeux actif comprenant de l'hydrogène en tant que gaz réactif, dans au moins un organe d'injection amont, afin d'éliminer au moins une partie de la couche limite d'oxygène présente à la surface du substrat, puis on injecte un second mélange gazeux actif différent du premier mélange gazeux actif, dans au moins un organe d'injection aval, à la surface du substrat libérée d'au moins une partie de ladite couche d'oxygène.

9. Procédé selon la revendication précédente, dans lequel le ou chaque organe d'injection amont est prévu dans une chambre supplémentaire amont, distincte de l'enceinte, alors que le ou chaque organe d'injection aval est prévu dans l'enceinte.

10. Procédé selon la revendication 8, dans lequel le ou chaque organe d'injection amont est prévu dans une première tête, ou tête amont, de l'enceinte, alors que le ou chaque organe d'injection aval est prévu dans une seconde tête, ou tête aval, de l'enceinte.

11. Procédé selon la revendication 8, dans lequel le ou chaque organe d'injection amont, ainsi le ou chaque organe d'injection aval, sont prévus dans une unique tête.

12. Procédé selon l'une des revendications précédentes, dans lequel on fait passer le substrat dans une chambre auxiliaire (221), placée en amont de l'enceinte, et on presse ce substrat au moyen d'au moins un rouleau (222, 222') reçu dans cette chambre auxiliaire, afin d'éliminer au moins partiellement la couche d'air présente à la surface du substrat.

13. Procédé selon la revendication 12, dans lequel on met en dépression le volume intérieur de cette chambre auxiliaire.

14. Installation pour la mise en oeuvre d'un procédé selon l'une quelconque des revendications précédentes, comprenant
- une enceinte (10; 110; 210);
- un support (20; 120; 220) pour le substrat (SUB), reçu dans ladite enceinte;
- une contre électrode (20; 120; 220);
- au moins une tête (30; 130₁-130ₙ; 230), définissant un volume intérieur (V) ouvert en direction du support, ladite tête étant pourvue
- d'au moins une électrode (8, 8', 8") adaptée pour coopérer avec ladite contre électrode pour créer une décharge électrique;
- de moyens de diffusion (42), pour la diffusion d'un gaz inerte vers ledit support; et
- de moyens d'injection (7, 7', 7") pour l'injection d'au moins un mélange gazeux actif vers ledit support, ce mélange gazeux actif comprenant un gaz réactif propre à être activé par ladite décharge électrique ;
- les moyens d'injection étant placés entre les moyens de diffusion et le support, **caractérisée en ce que** la tête et le support définissent au moins une sortie (S) pour le gaz inerte et/ou le mélange gazeux actif et **en ce que** cette installation comprend en outre des moyens de réglage de la section efficace de la sortie et/ou des moyens de réglage du débit total du gaz inerte et du mélange gazeux actif.

15. Installation selon la revendication précédente, **caractérisée en ce qu'**elle comprend en outre une chambre auxiliaire (221), placée en amont de l'enceinte, ladite chambre auxiliaire étant munie d'au moins un rouleau de pressage (222, 222') adapté pour éliminer au moins partiellement la couche d'air présente à la surface du substrat.

## Patentansprüche

1. Verfahren zur Behandlung der Oberfläche eines Substrats (SUB) in Bewegung in einer Anlage, umfassend
- ein Gehäuse (10; 110; 210);
- einen Träger (20; 120; 220) für das Substrat, aufgenommen in dem Gehäuse;
- eine Gegenelektrode (20; 120; 220);
- mindestens einen Kopf (30; 130₁-130ₙ; 230), der ein in Richtung des Trägers offenes Innenvolumen (V) definiert, wobei der Kopf ausgerüstet ist mit
- mindestens einer Elektrode (8, 8', 8"), die geeignet ist, um mit der Gegenelektrode zusammenzuwirken, um eine elektrische Entladung zu erzeugen;
- Verteilungsmitteln (42) zum Verteilen eines Inertgases zum Träger; und
- Einleitungsmitteln (7, 7', 7"), die sich von den Verteilungsmitteln unterscheiden, zum Einleiten von mindestens einem aktiven Gasgemisch zum Träger, wobei dieses aktive Gasgemisch ein reaktives Gas umfasst, das imstande ist, von der elektrischen Entladung aktiviert zu werden;
- wobei die Einleitungsmittel zwischen den Verteilungsmitteln und dem Träger platziert sind;
wobei bei dem Verfahren
(i) das Inertgas und das aktive Gasgemisch gleichzeitig zu dem Träger derart eingeleitet werden, dass das aktive Gasgemisch gegen den Träger gedrückt wird;
(ii) das reaktive Gas in der elektrischen Entladung aktiviert wird und die Oberfläche des Substrats in Bewegung behandelt wird;
(iii) durch den Auslass (S) die gasförmige Atmosphäre aus dem Innenvolumen (V) ausgeleitet wird, wobei die gasförmige Atmosphäre einen Teil des Inertgases und des aktiven Gasgemischs umfasst;
**dadurch gekennzeichnet, dass** der Kopf und der Träger mindestens einen Auslass (S) für das Inertgas und/oder das aktive Gasgemisch definieren und dadurch, dass
(iv) der effektive Querschnitt des Auslasses (S) eingestellt wird und/oder die Gesamtmenge des Inertgases und des aktiven Gasgemischs eingestellt wird derart, dass der Druckunterschied zwischen dem Innenvolumen (V) jedes Kopfs und dem Innenvolumen des Gehäuses größer als 10 Pascal ist,
wobei die Schritte (i) bis (iv) nicht notwendigerweise chronologisch sind.

2. Verfahren nach Anspruch 1, wobei der effektive Querschnitt des Auslasses eingestellt wird und/oder die Gesamtmenge des Inertgases und des aktiven Gasgemischs eingestellt wird derart, dass der Druckunterschied zwischen dem Innenvolumen jedes Kopfs und dem Innenvolumen des Gehäuses größer als 20 Pascal, insbesondere größer als 50 Pascal ist.

3. Verfahren nach Anspruch 1 oder 2, wobei die Sauerstoffkonzentration im Innenvolumen jedes Kopfs gemessen wird und der effektive Querschnitt des Auslasses eingestellt wird und/oder die Gesamtmenge des Inertgases und des aktiven Gasgemischs eingestellt wird, wenn diese gemessene Konzentration außerhalb eines vorbestimmten Bereichs liegt.

4. Verfahren nach einem der vorangehenden Ansprüche, wobei das aktive Gasgemisch neben dem reaktiven Gas ein Trägergas umfasst.

5. Verfahren nach Anspruch 4, wobei ein Inertgas eines ersten Typs, vor allem Stickstoff, und ein Trägergas eines anderen Typs, vor allem Helium, verwendet werden.

6. Verfahren nach Anspruch 5, wobei ein Trägergas ausgewählt wird, das in Bezug auf Stickstoff verbesserte plasmabildende Eigenschaften aufweist, wie ein Edelgas wie Helium oder Argon.

7. Verfahren nach einem der vorangehenden Ansprüche, wobei das reaktive Gas mindestens ein Monomer und/oder mindestens ein Dotierungsmittel umfasst.

8. Verfahren nach einem der vorangehenden Ansprüche, wobei ein erstes aktives Gasgemisch, umfassend Wasserstoff als reaktives Gas, in mindestens ein vorgelagertes Einleitungsorgan eingeleitet wird, um mindestens einen Teil der Sauerstoff-Grenzschicht zu entfernen, die auf der Oberfläche des Substrats vorhanden ist, dann ein zweites aktives Gasgemisch, das sich von dem ersten aktiven Gasgemisch unterscheidet, in mindestens ein nachgelagertes Einleitungsorgan eingeleitet wird, auf die von mindestens einem Teil der Sauerstoffschicht befreite Oberfläche des Substrats.

9. Verfahren nach vorangehendem Anspruch, wobei das oder jedes vorgelagerte Einleitungsorgan in einer vorgelagerten zusätzlichen Kammer, die sich von dem Gehäuse unterscheidet, vorgesehen ist, wogegen das oder jedes nachgelagerte Einleitungsorgan in dem Gehäuse vorgesehen ist.

10. Verfahren nach Anspruch 8, wobei das oder jedes vorgelagerte Einleitungsorgan in einem ersten Kopf oder vorgelagerten Kopf des Gehäuses vorgesehen ist, wogegen das oder jedes nachgelagerte Einleitungsorgan in einem zweiten Kopf oder nachgelagerten Kopf des Gehäuses vorgesehen ist.

11. Verfahren nach Anspruch 8, wobei das oder jedes vorgelagerte Einleitungsorgan sowie das oder jedes nachgelagerte Einleitungsorgan in einem einzigen Kopf vorgesehen sind.

12. Verfahren nach einem der vorangehenden Ansprüche, wobei das Substrat in eine Hilfskammer (221) übertragen wird, die dem Gehäuse vorgelagert platziert ist, und dieses Substrat mit mindestens einer Presswalze (222, 222') gepresst wird, die in dieser Hilfskammer aufgenommen ist, um die Luftschicht, die auf der Oberfläche des Substrats vorhanden ist, mindestens teilweise zu entfernen.

13. Verfahren nach Anspruch 12, wobei das Innenvolumen dieser Hilfskammer in Unterdruck versetzt wird.

14. Anlage für die Durchführung des Verfahrens nach einem der vorangehenden Ansprüche, umfassend
- ein Gehäuse (10; 110; 210);
- einen Träger (20; 120; 220) für das Substrat (SUB), aufgenommen in dem Gehäuse;
- eine Gegenelektrode (20; 120; 220);
- mindestens einen Kopf (30; 130₁-130ₙ; 230), der ein in Richtung des Trägers offenes Innenvolumen (V) definiert, wobei der Kopf ausgerüstet ist mit
- mindestens einer Elektrode (8, 8', 8"), die geeignet ist, um mit der Gegenelektrode zusammenzuwirken, um eine elektrische Entladung zu erzeugen;
- Verteilungsmitteln (42) zum Verteilen eines Inertgases zum Träger; und
- Einleitungsmitteln (7, 7', 7") zum Einleiten von mindestens einem aktiven Gasgemisch zum Träger, wobei dieses aktive Gasgemisch ein reaktives Gas umfasst, das imstande ist, von der elektrischen Entladung aktiviert zu werden;
- wobei die Einleitungsmittel zwischen den Verteilungsmitteln und dem Träger platziert sind,
**dadurch gekennzeichnet, dass** der Kopf und der Träger mindestens einen Auslass (S) für das Inertgas und/oder das aktive Gasgemisch definieren und dadurch, dass diese Anlage ferner Mittel zum Einstellen des effektiven Querschnitts des Auslasses und/oder Mittel zum Einstellen der Gesamtmenge des Inertgases und des aktiven Gasgemischs umfasst.

15. Anlage nach vorangehendem Anspruch, **dadurch gekennzeichnet, dass** sie ferner eine Hilfskammer (221) umfasst, die dem Gehäuse vorgelagert platziert ist, wobei die Hilfskammer mit mindestens einer Presswalze (222, 222') ausgestattet ist, die geeignet ist, um die Luftschicht, die auf der Oberfläche des Substrats vorhanden ist, mindestens teilweise zu entfernen.

## Claims

1. Method for treating the surface of a moving substrate (SUB), in a facility comprising
- an enclosure (10; 110; 210);
- a support (20; 120; 220) for the substrate, received in said enclosure;
- a counter-electrode (20; 120; 220);
- at least one head (30; 130₁-130ₙ; 230), defining an inner volume (V) open in the direction of the support, said head being provided with
- at least one electrode (8, 8', 8") suitable for cooperating with said counter-electrode in order to create an electrical discharge;
- means for diffusing (42), for diffusing an inert gas towards said support; and
- means for injecting (7, 7', 7"), separate from the means for diffusing, for injecting at least one active gas mixture towards said support, with this active gas mixture comprising a reactive gas capable of being activated by said electrical discharge;
- the means for injecting being positioned between the means for diffusing and the support;
method in which
(i) both the inert gas and the active gas mixture are introduced towards said support, in such a way as to thrust the active gas mixture against said support;
(ii) the reactive gas is activated in said electrical discharge and the surface of said moving substrate is treated;
(iii) the gaseous atmosphere from the inner volume (V) is discharged via said outlet (S), said gaseous atmosphere comprising a fraction of the inert gas and the active gas mixture;
**characterised in that** the head and the support define at least one outlet (S) for the inert gas and/or the active gas mixture and **in that**
(iv) the effective cross-section of the outlet (S) is adjusted and/or the total flow rate of the inert gas and the active gas mixture is adjusted, in such a way that the difference in pressures between the inner volume (V) of each head and the inner volume of the enclosure is greater than 10 Pascal,
knowing that the steps (i) to (iv) are not necessarily chronological.

2. Method according to claim 1, wherein the effective cross-section of the outlet is adjusted and/or the total flow rate of the inert gas and the active gas mixture is adjusted, in such a way that the difference in pressures between the inner volume of each head and the inner volume of the enclosure is greater than 20 Pascal, in particular greater than 50 Pascal.

3. Method according to claim 1 or 2, wherein the concentration in oxygen in the inner volume of each head is measured and the effective cross-section of the outlet is adjusted and/or the total flow rate of the inert gas and the active gas mixture is adjusted, if this measured concentration is located outside a predetermined range.

4. Method according to one of the preceding claims, wherein the active gas mixture comprises, in addition to the reactive gas, a carrier gas.

5. Method according to claim 4, wherein an inert gas of a first type, in particular nitrogen, and a carrier gas of a different type, in particular helium, are used.

6. Method according to claim 5, wherein a carrier gas that has improved plasma properties with respect to nitrogen, such as a noble gas such as helium or argon, is chosen.

7. Method according to one of the preceding claims, wherein the reactive gas comprises at least one monomer and/or at least one dopant.

8. Method according to one of the preceding claims, wherein a first active gas mixture comprising hydrogen as a reactive gas, is injected into at least one upstream injection member, so as to eliminate at least one portion of the boundary layer of oxygen present on the surface of the substrate, then a second active gas mixture different from the first active gas mixture, is injected into at least one downstream injection member, on the surface of the substrate released from at least one portion of said oxygen layer.

9. Method according to the preceding claim, wherein the or each upstream injection member is provided in an upstream additional chamber, separate from the enclosure, while the or each downstream injection member is provided in the enclosure.

10. Method according to claim 8, wherein the or each upstream injection member is provided in a first head, or upstream head, of the enclosure, while the or each downstream injection member is provided in a second head, or downstream head, of the enclosure.

11. Method according to claim 8, wherein the or each upstream injection member, as well as the or each downstream injection member, are provided in a single head.

12. Method according to one of the preceding claims, wherein the substrate is made to pass into an auxiliary chamber (221), positioned upstream of the enclosure, and this substrate is pressed by means of at least one roller (222, 222') received in this auxiliary chamber, so as to at least partially eliminate the layer of air present on the surface of the substrate.

13. Method according to claim 12, wherein the inner volume of this auxiliary chamber is depressurised.

14. Facility for the implementing of a method according to any preceding claim, comprising
- an enclosure (10; 110: 210);
- a support (20; 120; 220) for the substrate (SUB), received in said enclosure;
- a counter-electrode (20; 120; 220);
- at least one head (30; 130₁-130ₙ; 230), defining an inner volume (V) open in the direction of the support, said head being provided with
-- at least one electrode (8, 8', 8") suitable for cooperating with said counter-electrode in order to create an electrical discharge;
-- means for diffusing (42), for diffusing an inert gas towards said support; and
-- means for injecting (7, 7', 7") for injecting at least one active gas mixture towards said support, with this active gas mixture comprising a reactive gas capable of being activated by said electrical discharge;
-- the means for injecting being positioned between the means for diffusing and the support, **characterised in that** the head and the support define at least one outlet (S) for the inert gas and/or the active gas mixture and **in that** this facility further comprises means for adjusting the effective cross-section of the outlet and/or of the means for adjusting the total flow rate of the inert gas and of the active gas mixture.

15. Installation according to the preceding claim, **characterised in that** it further comprises an auxiliary chamber (221), positioned upstream of the enclosure, said auxiliary chamber being provided with at least one pressing roller (222, 222') suitable for eliminating at least partially the layer of air present on the surface of the substrate.
